Europäisches Patentamt

European Patent Office

Office européen des brevets

(19)

(11) Publication number: **0 365 169**
**A1**

## (12) EUROPEAN PATENT APPLICATION

(21) Application number: 89310058.6

(51) Int. Cl.⁵: **H05K 3/02**

(22) Date of filing: 02.10.89

(30) Priority: 30.09.88 JP 247250/88

(43) Date of publication of application:
25.04.90 Bulletin 90/17

(84) Designated Contracting States:
DE FR GB

(71) Applicant: **MOLEX INCORPORATED**
**2222 Wellington Court**
**Lisle Illinois 60532(US)**

(72) Inventor: **Enomoto, Masahiro**
**12-1 Hirao**
**Inagi-shi Tokyo(JP)**
Inventor: **Itoh, Takao**
**20-275 Nishiuraga-cho**
**Yokosuka-shi(JP)**
Inventor: **Nakanishi, Takeshi**
**3027 Sizunami Haibara-cho**
**Haibara-gun Sizuoka(JP)**

(74) Representative: **Slight, Geoffrey Charles et al**
**Graham Watt & Co. Riverhead**
**Sevenoaks Kent TN13 2BN(GB)**

(54) **Method of producing a printed wiring board.**

(57) A board (3) formed with a recess (2) is copper plated. Then the board is printed with a resist ink (6) using a pad (9). In order to ink the pad (9) an intaglio printing plate (8) is prepared with a recessed pattern (7), the plate (8) is inked and the ink is transferred to the pad by printing. A conventional etching process is then carried out to form the printed wiring board with a pattern of conductors (12).

Fig 6

EP 0 365 169 A1

## METHOD OF PRODUCING A PRINTED WIRING BOARD

The present invention relates generally to a method of producing a printed wiring board and more particularly, to a new and improved method in which a resist ink is deposited on a surface of a printing plate at a recessed portion and/or a convex portion possibly as well as a flat portion thereof and the ink deposited is transferred therefrom to a recessed portion and/or a convex portion possibly as well as a flat portion of a board to form a conductor pattern thereon.

With the tendency of increasing the demands for highly compact and low profile electric and electronic components, the printed circuit boards used therewith become modified, and designed in such a manner that the boards have not only flat portions but also recessed portions on the surfaces thereof, the conductor patterns are formed on the recessed portions, and the electronic and electric components are mounted thereon. In other words, the conductor patterns are formed in a three dimensional configuration.

In such a configuration, considerable compactness and low profile form of the board itself is achieved, even with the electronic and electric components mounted thereon, and thus compactness of an electronic or electric device with such a board incorporated unit can be achieved, and high density wiring of the board can also be realised. In addition, where electronic and electric components are desired to be economically manufactured, it is possible that the housings or casings of the components themselves can form printed wiring boards with recessed and/or convex portions formed on such housings or casings, the conductor patterns being deposited thereon, and the electronic and electric components then mounted in the housings or casings. In such arrangements, not only compactness and low profile shape, but also low cost of the printed wiring boards can be realised.

A number of techniques for forming a conductor pattern on a recessed portion of a board are already known.

The Japanese Patent Publications Nos. 1979-13970, 1986-88279, 1986-89724, 1983-67099, 1983-67098 and others disclose one example of such technique in which a housing or casing having recessed and convex portions is used as a printed wiring board so that the conductor pattern is formed on the recessed portions of the housing.

In addition, Japanese Patent Publications Nos. 1979-20368 and 1986-220395 disclose another technique that is generally used to form a conductor pattern on a recessed portion of a board.

These conventional conductor forming techniques, sometimes called "Subtractive Method" techniques, consist of the steps of: subjecting a plate to an activation process; plating a surface of the plate with a metal by an electrolytic plating process; depositing a resist ink on the surface of said plate; subjecting said plate to an etching process; and transferring the resist ink deposited on said plate surface to a surface of a board to form a pattern of the required conductors thereon. According to such conventional techniques, metal conductors are then electrically deposited on recessed portions by an electroplating or a vapor deposition process. Alternatively, a hot-stamping process may be used to deposit conductor foils on the recessed portions.

In view of the above, although the prior art techniques provide individual advantages, there still remain several difficulties in that these techniques for electrical deposition or vapor deposition of metal particles are only effective on the recessed portions rather than the flat portions of the board surface, with the result that special considerations must be undertaken for which complicated and expensive machines are necessary.

In addition, complicated and elaborate operations for precisely forming the conductor patterns on the recessed portions are also required. On the other hand, the hot-stamping technique for hot-stamping the conductor foil can be effected in relatively simple facilities to relatively precisely form the conductor pattern only on the convex portions of the board. The conductor pattern, however, does not compliably form on the recessed portions of the board. Therefore, in order to precisely form the conductor pattern on the recessed portions of the board, there remains the need for improving such hot-stamping technique.

It is apparent from the foregoing that the prior art techniques described above have advantages over the subtractive method for producing a printed wiring board in that they can be used to produce the printed circuit in a three-dimensional configuration, but they still have many problems to be solved.

In order to solve these problems, the present inventors have addressed their attention towards the conventional subtractive method for producing a printed wiring board, and improved the resist ink transfer step of said method to develop the characteristic features of the present invention.

According to the present invention there is provided a method of producing a printed wiring board comprising the process steps of: subjecting a plastics plate to an activation process; plating a surface of said plastics plate with a kind of metal by an electrolysis plating process; depositing a resist ink on the surface of said plastics plate; subjecting said plate to an etching process; and transferring the resist ink deposited on said plate surface to a surface of a board to produce a conductor pattern thereon, characterised in that said process step of transferring the resist ink in order to produce the conductor pattern on at least a recessed portion on said board comprises the steps of:

producing an intaglio plate having a recessed pattern arranged on the surface thereof corresponding to said conductor pattern to be produced;

depositing the resist ink on said recessed pattern arranged on the surface of said intaglio plate;

pressing a rubber pad against the surface of said intaglio plate, and transferring said resist ink to a pad surface of said rubber pad in a pattern corresponding to said recessed patern; and

pressing said rubber pad having the transferred resist ink on its pad surface against said board having the recessed portion arranged on the surface thereof, thereby transferring said resist ink to said recessed portion of the board.

In use of the present method described above, in addition to the recessed portion of said board, the resist ink can concurrently be transferred to convex and/or flat portions of the board surface by means of said rubber pad and thereafter the conductor pattern can be formed. Alternatively, only flat surface portions of the board may receive deposits of the resist ink by means of a silk screening process. Moreover, the surface portion may be plated with a metal by an electrolytic plating process, followed by a further metal plating process.

Embodiments of the present invention will now be described in detail by way of example with reference to the accompaning drawings in which:

FIG. 1 is a flow chart explaining an entire process according to the present invention;

FIGS. 2 to 6 represent a sequence of steps for applying resist ink on recesses and a flat surface of a board using a rubber pad;

FIG. 7 is a top view of a printed wiring board produced according to the present invention; and

FIG. 8 represents cross-sectionally the recesses of the printed wiring board.

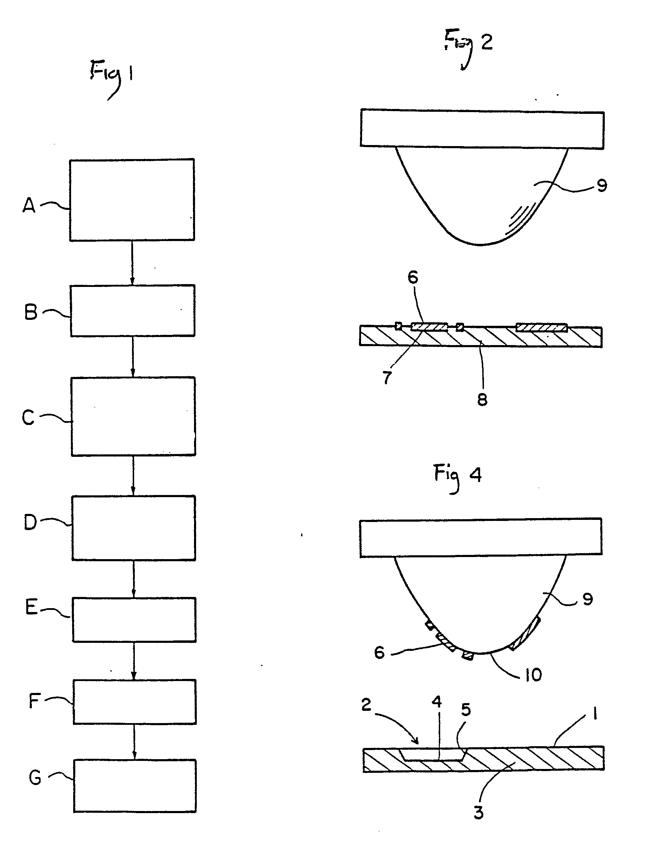

With reference now to the drawings, Fig. 1 is a flow chart representing an entire process in accordance with the subtractive method sometimes simply called the "etching method" for producing printed wiring boards. Briefly, in a step A, a board 3 with a recess 2 arranged in a predetermined pattern on its surface 1 is formed by injection molding. In this regard, the board 3 may be a simple flat plate or a cabinet or housing itself, depending upon the requirements of the finished products, and preferably it is made of plastics material such as liquid crystal for injection molding.

One or several recesses 2 may be arranged on the board 3 at predetermined positions based upon the design for wiring in order to mount the electric and/or electronic components within those recesses 2 after completion of the printed wiring boards for end products. Further, a recess 2 having any size and deepness may be made depending upon the intended application. It suffices to say here that a recess 2 having a bottom wall 4 and a tapered peripheral wall 5 is formed in the board 3.

Then in a step B, the surface of the board is subjected to a conventional activation process. In the next step C, the board surface is subjected to an electrolytic copper plating process. Of course, depending on the types of products, other metals than copper can be electroplated on the board surface. In addition to such electrolytic plating, an electroplated layer of a second metal may be applied to the resultant copper layer on the board.

Then, a pad printing process is carried out using resist ink 6 in a step D. The resist ink 6 is, of course, applied in a printing pattern corresponding to that of the conductors to be formed on the board. The pad printing process is used to deposit the resist ink 6 in the recess 2 of the board. Alternatively, the printing process may be used to deposit the resist ink on further, e.g., the convex and flat portions, of the board surface or a conventional silk screening process may be used to deposit the resist ink on the flat portions of the board surface 1. This step D will be further described hereinafter with reference to Fig. 2.

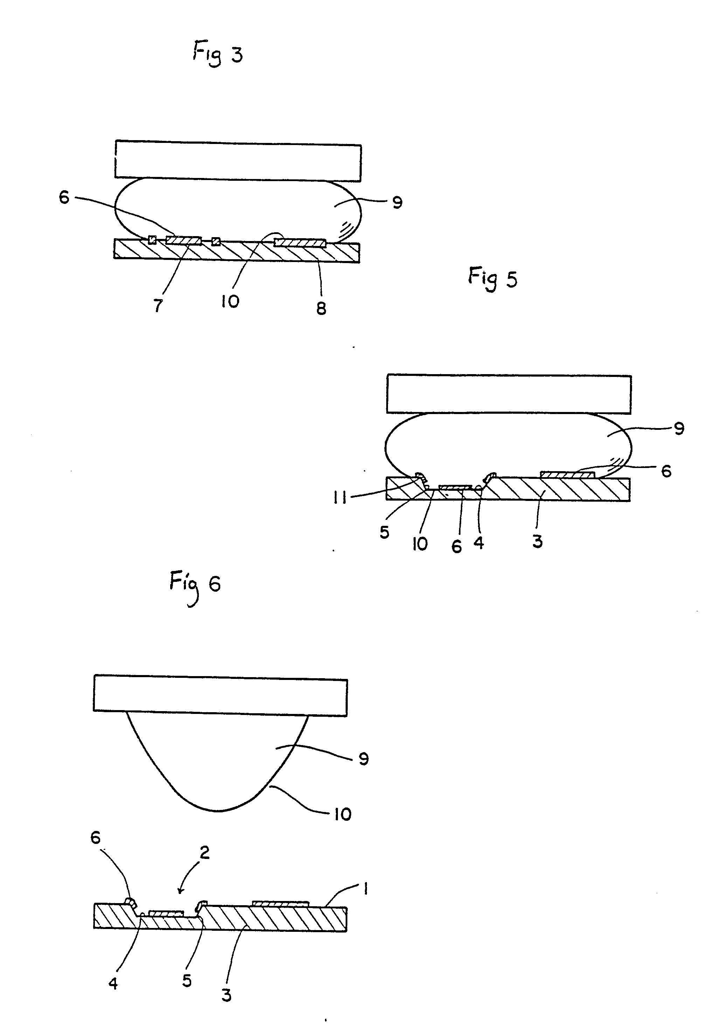

A photosensitive intaglio printing plate 8 having a recessed pattern 7 thereon is produced according to a process as shown in Fig. 2. This process is not illustrated in detail, but is effected in such manner that a photosensitive surface of the plate is exposed to light through a positive film, the board surface is washed to remove the unexposed portions, the board surface is then dried with a hot air, and subsequent steps such as post-exposure and the like steps are then performed to produce a complete intaglio printing plate 8. Said recessed pattern 7, of course, corresponds to a conductor pattern subsequently produced. Then resist ink 6 is deposited in the recessed pattern 7 on the intaglio plate 8, and a tool such as a doctor blade is used to remove excess ink. The next step shown in Fig. 3 is then performed in which a rubber pad 9 made of any suitable material such as silicone rubber or the like is pressed with its pad surface 10 against the plate surface, thereby transferring the resist ink 6 therefrom to the pad surface 10 as shown in Fig. 4. Such transfer of the resist ink 6 is effected in a pattern corresponding to the recessed pattern 7 which then corresponds to the conductor pattern to be produced. Thereafter, in Fig. 4, the board 3 having the copper layer deposited thereon in the step C as stated above is disposed at a predetermined position under the rubber pad 9.

Then, as shown in Fig. 5, the rubber pad 9 is moved downwardly to press the pad surface 10 against the surface 1 of the board 3. This enables the transfer of the resist ink 6 on the pad surface 10 to the bottom wall 4 of the recess 2 as well as to the tapered inner peripheral wall 5 of the recess. Although in this embodiment, the resist ink 6 is transferred to both the bottom and the inner peripheral walls 4 and 5 of the recess 2, the resist ink may be transferred to either the bottom wall 4 only or to the peripheral wall 5 only and/or to any predetermined flat portions of the board surface 1 either solely or additionally.

More particularly, with regard to the transfer of the resist ink 6 to the tapered inner peripheral wall 5, the resist ink 6 is shown transferred not only to the tapered peripheral wall 5 itself, but also to an edge surface 11 adjoining thereto. It is important that because of the flexibility of the rubber pad 9, the pad surface 10 can be easily received in the recess 2 and made to comply with the shape thereof. In addition, each portion of the pad surface 10 can be uniformly deformed when the rubber pad 9 is pressed against the recess 2 and the flat portions of the board surface, thereby enabling the reliable transfer of the resist ink 6 to the bottom 4 and the inner peripheral wall 5 of the recess 2 if desired.

Then, referring to Fig. 6, the rubber pad 9 is moved upwardly to disengage from the surface of the board 3. Because the rubber pad 9 is made of silicone rubber and has a higher releasability than the board surface, there is no possibility that any of the deposited resist ink 6 remains on the pad surface 10 of the rubber pad 9.

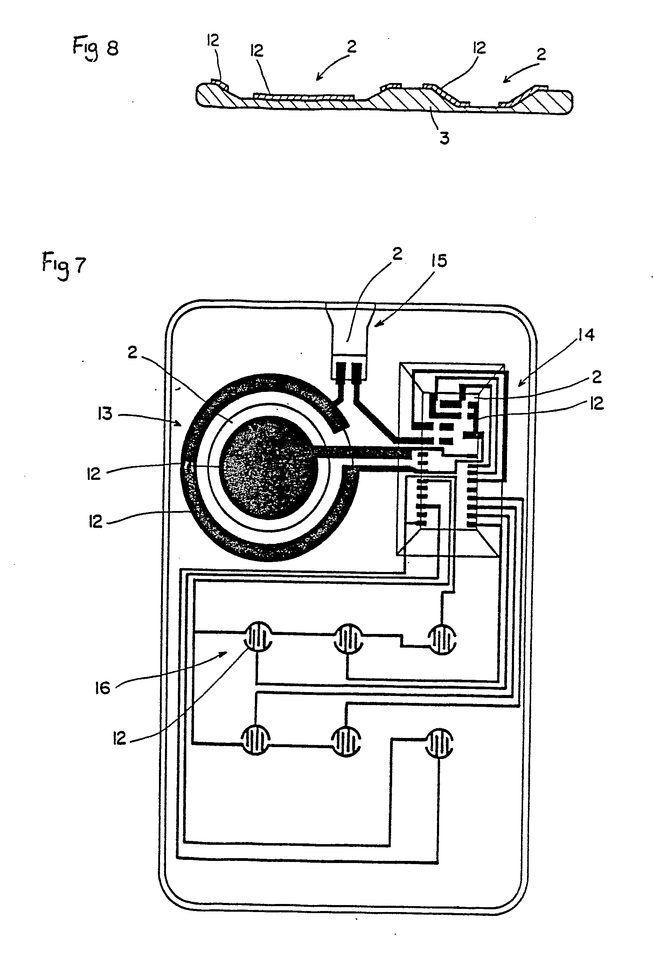

After the resist ink 6 is deposited on the bottom 4 and the tapered inner peripheral wall 5 of the recess 2 on the board 3 as described, a conventional etching process is carried out at step E in Fig. 1. More precisely, those portions of the copper plated layer where the resist ink 6 is not deposited are eroded away by this etching process. In the next step indicated by block F in Fig. 1, the resist ink 6 is stripped off the surface of the board, and in the subsequent step indicated by block G, conductors 12 are arranged in the conductor pattern on the board surface. Figs. 7 and 8 show one example of the board 3 thus produced in plan and in cross-section, respectively.

The printed wiring board as shown in Figs. 7 and 8 is, by way of example, incorporated in a remote controller for a television receiver set. Referring to Fig. 7, a battery is installed in the recess 2 of a compartment 13, a semiconductor chip for control is installed in the recess 2 of a compartment 14 and a light emitting diode is installed in the recess 2 of a compartment 15. In addition, the conductor pattern 12 in a section 12 provides a switching section on which resilient switch plates are mounted. Various types of conductor patterns can be designed according to the intended use of the boards.

There has been described with reference to the drawings, improved and highly reliable board manufacturing methods based upon a conventional etching process. The methods utilize a pad printing process rather than a silk screening process for the precise deposition of the resist ink and thus for the ease and precise production of the conductor pattern in the recesses of the board. Therefore, the method can be realised by simple apparatus and easy operation.

It is apparent from the foregoing that the methods described with reference to the drawings provide several advantages as stated hereunder.

Namely, the conventional and already reliably established manufacturing method of the printed wiring board using a prior etching process is effectively utilized and improved by taking advantage of a pad printing process, which enables the precise and reliable patterning of conductors on the recesses of a board surface. More specifically, if the conventional manufacturing method is used to produce a printed wiring board, it is difficult to precisely form the conductors in the recesses of the board in reliably conforming alignment therewith. In contrast to this, because of the pad printing process used for deposition of the resist ink in the manner described and illustrated in the drawings, it is possible to deposit the resist ink and thus eventually the conductors in the recesses of a board surface while enabling the processing of the entire board by means of an etching process to produce a precise printed wiring board.

Furthermore, the methods as described and illustrated can be realised by relatively simple machines and facilities and, therefore, the processing operations can also be readily performed.

## Claims

1. A method of producing a printed wiring board comprising subjecting a plate to an activation process; plating a surface of said plate with a selected material; depositing a resist ink on said surface; subjecting said surface to an etching process; and transferring the resist ink deposited on said surface to a surface of a board to produce a conductor pattern thereon, characterized in that said process step of transferring the resist ink (6) in order to produce the conductor pattern (12) on at least a recessed surface portion of said surface (2) of said board (3) comprises the steps of:

producing an intaglio plate (8) having a recessed pattern (7) arranged on the surface thereof corresponding to said conductor pattern to be produced;

depositing the resist ink (6) on said recessed pattern (7) arranged on the surface of said intaglio plate (8);

pressing a rubber pad (9) against the surface of said intaglio plate, and transferring said resist ink (6) to a pad surface (10) of said rubber pad (9) in a pattern corresponding to said recessed pattern (7);

pressing said rubber pad (9) having the transferred resist ink (6) on its pad surface (10) against the recessed surface portion (2) of said board, thereby transferring said resist ink (6) to said recessed surface portion (2) of the board.

2. A method according to claim 1 further comprising after plating said surface of said plate with a first metal, further plating said plate surface with a second metal.

3. A method according to claim 1 or 2 further comprising transferring the resist ink (6) in order to produce the conductor pattern (12) on a convex portion of the surface (1) of said board (3).

4. A method according to any preceding claim further comprising transferring the resist ink (6) in order to produce the conductor pattern (12) on a flat portion of the surface (1) of said board (3).

5. A method according to any preceding claim in which said conductor pattern (12) is formed only on the bottom (4) of said recess (2).

6. A method according to any preceding claim in which said recess (2) has a tapered inner peripheral wall (5) and said conductor pattern (12) is formed only on said peripheral wall (5).

7. A method according to any preceding claim in which said board (3) itself constitutes a housing for an electronic or electric device.

Fig 1

A

B

C

D

E

F

G

Fig 2

9

6

7    8

Fig 4

9

6

10

2    4    5    1

3

EP 0 365 169 A1

Fig 3

Fig 5

Fig 6

Fig 8

Fig 7

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X | DE-A-3 201 065 (SCHWARZWÄLDER ELEKTRONIK-WERKE GmbH) * Claims; page 2, paragraph 2 * | 1,4 | H 05 K 3/02 |
| Y | --- | 6 | |
| A | PATENT ABSTRACTS OF JAPAN, vol. 10, no. 310 (C-379)[2366], 22nd October 1986; & JP-A-61 119 683 (NIPPON TELEGR. & TELEPH. CORP.) 06-06-1986 * Abstract * | 1 | |
| Y | IDEM --- | 6 | |
| A | US-A-3 701 317 (MIYAMOTO et al.) * Column 2, lines 31-63; column 5, lines 21-30; figure 1 * --- | 1,4 | |
| A | WO-A-8 301 886 (ROBERT BOSCH GmbH) * Claims 1,2; figures 1-3 * --- | 1,6 | |
| A | GB-A- 829 354 (ERIE RESISTOR LTD) * Claim 1; figures 1-5 * ----- | 1,4 | TECHNICAL FIELDS SEARCHED (Int. Cl.5) H 05 K |

The present search report has been drawn up for all claims

| Place of search | Date of completion of the search | Examiner |
|---|---|---|
| THE HAGUE | 09-02-1990 | MES L.A. |

EPO FORM 1503 03.82 (P0401)